**Europäisches Patentamt**

**European Patent Office**

**Office européen des brevets**

(11) Publication number: **0 104 925**
**B1**

# EUROPEAN PATENT SPECIFICATION

(45) Date of publication of patent specification: **09.08.89**

(51) Int. Cl.⁴: **H 01 L 27/02, B 41 J 3/20**

(21) Application number: **83305734.2**

(22) Date of filing: **26.09.83**

(54) Semiconductor device, for example, for a thermal head for a printer.

(30) Priority: **27.09.82 JP 168135/82**

(43) Date of publication of application:
**04.04.84 Bulletin 84/14**

(45) Publication of the grant of the patent:
**09.08.89 Bulletin 89/32**

(84) Designated Contracting States:
**DE FR GB**

(56) References cited:
**US-A-4 006 491**
**US-A-4 072 937**
**US-A-4 176 272**

**1982 SID INTERNATIONAL SYMPOSIUM, DIGEST OF TECHNICAL PAPERS, May 1982, pages 258-259, US; R.A. BLANCHARD: "High-voltage ICs for electroluminescent panels"**

(73) Proprietor: **SEIKO INSTRUMENTS INC.**
**31-1, Kameido 6-chome Koto-ku**
**Tokyo 136 (JP)**

(72) Inventor: **Matsuura, Yoshiaki**
**c/o Kabushiki Kaisha Daini Seikosha 6-31-1**
**Kameido Koto-ku Tokyo (JP)**

(74) Representative: **Caro, William Egerton et al**
**J. MILLER & CO. Lincoln House 296-302 High**
**Holborn**
**London WC1V 7JH (GB)**

(56) References cited:
**IEDM TECHNICAL DIGEST, INTERNATIONAL ELECTRON DEVICES MEETING, 8th-10th December 1980, Washington, DC, US, pages 70-74, IEEE, New York, US; J.D. PLUMMER: "Monolithic MOS high voltage integrated circuits"**

Courier Press, Leamington Spa, England.

**Description**

This invention relates to semiconductor devices, for example, semiconductor devices for thermal heads of printers.

In a semiconductor device for thermal heads of printers, a bipolar element has been used because a relatively large drive current was required, which resulted in thermal runaway and eventual thermal breakdown. The invention seeks to overcome this problem.

In a digest of a technical paper presented to the 1982 SID International Symposium entitled "High-Voltage ICs for Electroluminescent Panels" by Richard A. Blanchard, and published on pages 258 and 259 of the 1982 Digest of Technical Papers by the Society for Information Display, there is disclosed drive circuitry for electroluminescent display panels constructed as semiconductor devices including drive circuits and logic circuits. The structures were in MOS technology.

According to the invention, a semiconductor device comprising a drive circuit and a logic circuit connected in series, is characterised in that the drive circuit is constituted by an open-drain metal oxide semiconductor and is operated at a relatively high voltage at saturation according to temperature, and the logic circuit is constituted by a complementary metal oxide semiconductor and is operated at a relatively low voltage.

The drive circuit may consist of a P-channel metal oxide semiconductor or an N-channel metal oxide semiconductor.

Preferably, means are provided for driving the drive circuit and the logic circuit with different voltages.

The drive circuit may be arranged to supply a constant current.

According to a further aspect of the present invention, there is provided a thermal head for a printer including a semiconductor device according to the present invention.

The invention is illustrated, merely by way of example, in the accompanying drawings, in which:—

Figures 1a and 1b are plan and side views respectively of a thermal head for a printer;

Figure 2 is a diagram showing the basic arrangement of a heating element and drive circuit of the thermal head of Figure 1;

Figure 3 is a block diagram of a drive circuit and logic control circuit of a conventional thermal head;

Figure 4 is a diagram of one embodiment of a semiconductor device according to the present invention; and

Figure 5 illustrates a semiconductor device according to the present invention acting as a driver circuit for a thermal head of a printer.

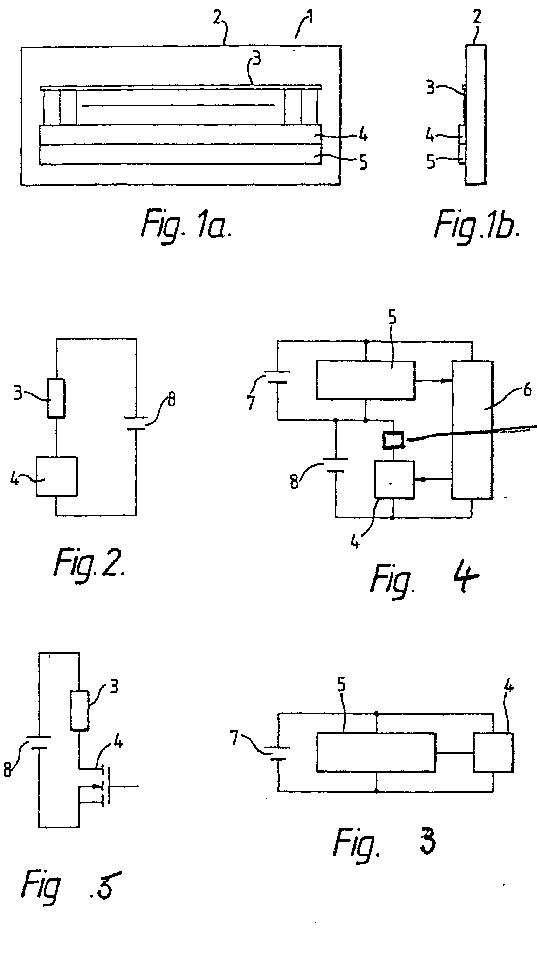

As shown in Figures 1a and 1b, a thermal head 1 for a printer consists of a heating resistor 3, a drive circuit 4, and a logic control circuit 5, these components being mounted on a ceramic substrate 2.

Since the heating resistor 3 consumes a relatively large current, a bipolar element is conventionally used in the drive circuit 4 for driving the thermal head. Figure 2 shows the basic arrangement of the heating resistor 3 and the drive circuit 4 which are connected in series with a power source 8. As the temperature rises, the leakage and the amplification factor of the bipolar element increases, so that the current consumed by the thermal head increases. Heat is generated by this increase in current and hence an even larger current flows. This phenomenon is sometimes referred to as "thermal runaway". If the bipolar element is mounted on the same substrate as the heating resistor, conditions worsen as a result of the heat generated and, if the substrate 2 has poor heat radiating efficiency, the bipolar element undergoes thermal breakdown. Thermal runaway and erroneous operation caused by heat raise serious problems regarding the reliability of conventional thermal heads.

Thermal heads mainly are of the linear type or the serial type. In recent years, linear thermal heads have been put into practice, and attention has been given to the generation of heat and consumption of large current by bipolar elements of such thermal heads. In a linear thermal head, 3 to 16 heat generator dots are provided per millimetre, and a driver circuit is provided for each. For printing a line on an A-4 page, about 1700 dots are required if 8 dots are provided per millimetre in the standard manner. Each dot must be supplied with a current of between 20 mA and 80 mA to generate heat, which requires a power source with a relatively large capacity. It therefore becomes necessary to reduce the current flowing in the logic control circuit to be as small as possible to minimise the load on the power source.

Figure 3 shows a conventional thermal head employing a bipolar element. The logic control circuit 5 and the drive circuit 4 are supplied with a voltage of 4 to 6 volts from a power source 7, to supply heating elements with a relatively high voltage of, for example, 15 to 30 volts.

Referring now to Figure 4, there is shown one embodiment of a semiconductor device according to the present invention incorporated into a thermal head for a printer. The drive circuit 4 is constituted by an open drain N-channel metal oxide semiconductor (MOS) to cope satisfactorily the voltage and current requirements, and the logic control circuit 5 is constituted by a complementary MOS to reduce current consumption. The development of a latch-up phenomenon by a high voltage and heavy current is prevented by using the N-channel MOS for the drive circuit 4. This same effect can be achieved using a P-channel MOS for the drive circuit 4 provided it has an open drain. The same effect can also be obtained using a complementary MOS, but this depends upon the conditions. A silicon substrate on which a complementary MOS is formed is usually N-type. When an N-channel MOS is used for the drive circuit 4, however, the silicon substrate must be of P-type.

The reason why a metal-oxide semiconductor is not subject to thermal runaway will now be explained. If the drive circuit 4 comprises an N-channel MOS as shown in Figure 4, current I flowing in the N-channel MOS is given by:

$$I = \frac{W\mu C}{L} \{(V_G - V_T)V_D - \frac{1}{2}V_{D2}\} \quad (1)$$

where:
I: current flowing in the N-channel MOS,
W: channel width of the N-channel MOS,
L: channel length of the N-channel MOS
$\mu$: mobility
C: gate capacity
$V_G$: gate voltage of the N-channel MOS,
$V_T$: threshold voltage of the N-channel MOS,
$V_D$: drain-source voltage of the N-channel MOS.

In equation (1), the parameters which change with temperature are the mobility $\mu$ and the threshold voltage $V_T$. The mobility $\mu$ has a negative temperature coefficient and, hence, acts to reduce the current I as the temperature rises. The threshold voltage $V_T$ also has a negative temperature coefficient so that the expression $(V_G - V_T)$ increases with temperature and this acts to increase the current I. In equation (1), the temperature coefficients of the mobility $\mu$ and the expression $(V_G - V_T)$ cancel and, hence, the current I is automatically prevented from increasing with any increase in temperature. Therefore, if thought is given as how to radiate the heat produced by the heating resistor or resistors of a thermal head, the heat produced by the drive circuit 4 and by the heating resistor or resistors will have no significant effect on reliability. Accordingly, if the thermal head is provided with a suitable radiator plate it can be manufactured at reduced cost, and reliability can be enhanced.

The semiconductor device of Figure 4 consists of the logic control circuit 5, the drive circuit 4 which is arranged to supply constant current, and a level shifter 6. Figure 5 illustrates the drive circuit 4 in detail connected in series with the heating resistor 3.

The logic control circuit 5 is driven by a relatively low voltage from the power source 7 to reduce its current comsumption, and the drive circuit 4 is driven by a relatively high voltage from the power source 8 via the level shifter 6. The heating resistor 3 which conventionally is driven by a bipolar element is here driven by a MOS. However, a current equivalent to that of the bipolar element must be supplied through the MOS, and thus a voltage as high as 15 to 30 volts must be applied to the drive circuit 4 from the level shifter 6. However, the logic control circuit 5, which consists of a CMOS, consumes a large current if it is driven by a voltage of 15 to 30 volts, which offsets the advantages of using a CMOS. An operating voltage of 4 volts to 6 volts is sufficient to accomplish speed of operation of less than 10 MHz required by the CMOS. For reasons of current consumption and stability of operation, therefore, a voltage of 4 volts to 6 volts is applied to the logic control circuit 5.

Up until now, a bipolar element has been used in the logic control circuit because a relatively large drive current was required, which resulted in thermal runaway and eventual thermal breakdown. According to the present invention, on the other hand, the relatively large drive current is obtained by a MOS. Namely, the drive circuit is operated at a relatively high voltage to correct the defects of the MOS, and the occurrence of thermal breakdown is prevented by utilising the saturation of the driving current according to temperature of the MOS. The consumption of electric current, moreover, is reduced by the use of a CMOS. That is, high-speed operation comparable to that of a bipolar element is accomplished with a current which is less than one-thirtieth of the current needed by a bipolar element.

The semiconductor device according to the present invention and described above when used in a thermal head has the advantages of small current consumption, high speed, and increased reliability and with any future increase in dot density of thermal heads should be able to operate at faster speeds.

A semiconductor device according to the present invention can be used not only with thermal heads but also with plasma display devices, fluorescent display tubes, and other devices which require a high voltage and large current. Further, although the drive circuit 4 has been dsecribed as being constituted by an N-channel MOS it may be constituted by a P-channel MOS or a CMOS.

**Claims**

1. A semiconductor device comprising a drive circuit (4) and a logic circuit (5) connected in series, characterised in that the drive circuit (4) is constituted by an open-drain metal oxide semiconductor and is operated at a relatively high voltage at saturation according to temperature, and the logic circuit (5) is constituted by a complementary metal oxide semiconductor and is operated at a relatively low voltage.

2. A semiconductor device as claimed in claim 1, characterised in that the drive circuit (4) consists of a P-channel metal oxide semiconductor.

3. A semiconductor device as claimed in claim 1, characterised in that the drive circuit (4) consists of an N-channel metal oxide semiconductor.

4. A semiconductor device as claimed in any preceding claim characterised in that means (7, 8) are provided for driving the drive circuit (4) and the logic circuit (5) with said respectively relatively high and low voltages.

5. A semiconductor device as claimed in any preceding claim, characterised in that the drive circuit (4) is arranged to supply a constant current.

6. A semiconductor device as claimed in any preceding claim, characterised in that the drive circuit (4) is in series with a heating element (3).

7. A thermal head for a printer, characterised by including a semiconductor device as claimed in any preceding claim.

## Patentansprüche

1. Halbleiteranordnung, die eine Treiberschaltung (4) und eine logische Schaltung (5) aufweist, welche in Reihe geschaltet sind, dadurch gekennzeichnet, daß die Treiberschaltung (4) von einem Metalloxid-Halbleiter mit offenem Drain-Anschluß gebildet wird und bei einer relativ hohen Sättigungsspannung entsprechend der Temperatur betrieben wird, und daß die logische Schaltung (5) von einem komplementären Metaloxid-Halbleiter gebildet wird und mit einer relativ niedrigen Spannung betrieben wird.

2. Halbleiteranordnung nach Anspruch 1, dadurch gekennzeichnet, daß die Treiberschaltung (4) einen P-Metalloxid-Halbleiter aufweist.

3. Halbleiteranordnung nach Anspruch 1, dadurch gekennzeichnet, daß die Treiberschaltung (4) einen N-Metalloxid-Halbleiter aufweist.

4. Halbleiteranordnung nach einem der vorangehenden Ansprüche, dadurch gekennzeichnet, daß Einrichtungen (7, 8) zum Treiben der Treiberschaltung (4) und der logischen Schaltung (5) mit jeweils der relativ hohen und niedrigen Spannung vorgesehen sind.

5. Halbleiteranordnung nach einem der vorangehenden Ansprüche, dadurch gekennzeichnet, daß die Treiberschaltung (4) derart ausgelegt ist, daß sie einen kontanten Strom liefert.

6. Halbleiteranordnung nach einem der vorangehenden Ansprüche, dadurch gekennzeichnet, daß die Treiberschaltung (4) in Reihe mit einen Heizelement (3) geschaltet ist.

7. Wärmekopf für einen Drucker, dadurch gekennzeichnet, daß er eine Halbleiteranordnung nach einem der vorangehenden Ansprüche umfaßt.

## Revendications

1. Un dispositif à semiconducteurs comprenant un circuit d'attaque (4) et un circuit logique (5) connectés en série, caractérisé en ce que le circuit d'attaque (4) est constitué par un dispositif métal-oxyde-semiconducteur à drain ouvert, et fonctionne à une tension relativement élevée à la saturation, en fonction de la température, et le circuit logique (5) est constitué par un dispositif métal-oxyde-semiconducteur complémentaire et fonctionne à une tension relativement basse.

2. Dispositif à semiconducteurs selon la revendication 1, caractérisé en ce que le circuit d'attaque (4) consiste en un dispositif métal-oxyde-semiconducteur à canal P.

3. Dispositif à semiconducteurs selon la revendication 1, caractérisé en ce que le circuit d'attaque (4) consiste en un dispositif mètal-oxyde-semiconducteur à canal N.

4. Dispositif à semiconducteurs selon l'une quelconque des revendications précédentes, caractérisé en ce qu'il comporte des moyens (7, 8) prèvus pour faire fonctionner le circuit d'attaque (4) et le circuit logique (5) avec les tensions respectives relativement élevée et relativement faible précitées.

5. Un dispositif à semiconducteurs selon l'une quelconque des revendications précédentes, caractérisé en ce que le circuit d'attaque (4) est conçu de façon à fournir un courant constant.

6. Un dispositif à semiconducteurs selon l'une quelconque des revendications précédentes, caractérisé en ce que le circuit d'attaque (4) est connecté en série avec un élément chauffant (3).

7. Une tête thermique pour une imprimante, caractérisée en ce qu'elle comprend un dispositif à semiconducteurs selon l'une quelconque des revendications précédentes.

Fig. 1a.

Fig.1b.

Fig.2.

Fig. 4

Fig .5

Fig. 3